## Europäisches Patentamt
## European Patent Office
## Office européen des brevets

(11) Veröffentlichungsnummer: **0 296 096**
**A2**

# (12) EUROPÄISCHE PATENTANMELDUNG

(21) Anmeldenummer: 88730128.1

(22) Anmeldetag: 27.05.88

(51) Int. Cl.⁴: **H 05 K 13/02**

(30) Priorität: 04.06.87 DE 3718984

(43) Veröffentlichungstag der Anmeldung:
21.12.88 Patentblatt 88/51

(84) Benannte Vertragsstaaten:
CH DE FR GB IT LI

(71) Anmelder: **Siemens Aktiengesellschaft Berlin und München**
**Wittelsbacherplatz 2**
**D-8000 München 2 (DE)**

(72) Erfinder: **Schäfer, Walter**
**Harriesstrasse 3**
**D-1000 Berlin 13 (DE)**

(54) **Vorrichtung zum Be- und/oder Entladen einer Leiterplattenbearbeitungseinrichtung.**

(57)
1. Vorrichtung zum Be- und/oder Entladen einer Leiterplattenbearbeitungseinrichtung.

2.1. In Leiterplattenbearbeitungseinrichtungen werden die Funktionen des Vereinzelns der zu bearbeitenden Leiterplatten aus einer Leiterplattenspeichereinrichtung, das Wenden der Leiterplatte und das Drehen in separaten Bausteinen vorgenommen. Dies führt zu einer verhältnismäßig großen Leiterplattenbearbeitungsanlage.

2.2. Zur Erzielung einer Leiterplattenbearbeitungsanlage mit einem möglichst kompakten Aufbau ist eine wendbare Leiterplattenaufnahmeeinrichtung (9) zusätzlich um eine vertikale Achse (37) drehbar.

2.3. Die Vorrichtung ist besonders in Leiterbearbeitungseinrichtungen für SMD-Bauelemente geeignet.

FIG. 2

EP 0 296 096 A2

**Beschreibung**

## Vorrichtung zum Be- und/oder Entladen einer Leiterplattenbearbeitungseinrichtung

Die Erfindung bezieht sich auf eine Vorrichtung zum Be- und/oder Entladen einer Leiterplattenbearbeitungseinrichtung, insbesondere einer Leiterplattenbestückeinrichtung, mit einer der Leiterplattenbearbeitungseinrichtung zugeordneten, die jeweilige Leiterplatte aufnehmenden Zwischeneinrichtung mit wendbarer Leiterplattenaufnahmeeinrichtung.

Leiterplattenbearbeitungseinrichtungen werden im allgemeinen die zu bearbeitenden Leiterplatten in Leiterplattenspeichereinrichtungen zugeführt, bei denen es sich in der Regel um Magazine handelt, in denen die zu bearbeitenden Leiterplatten übereinander angeordnet sind. Zur Bearbeitung der einzelnen Leiterplatten sind diese jeweils für sich aus dem Magazin zu entnehmen, was bei einer offenkundig vorbenutzten Siemens-Anlage zur SMD (surface mounted device) - Bestückung durch eine Vereinzelungseinrichtung erfolgt, die in einer Anlage mit einer Leiterplattenbearbeitungseinrichtung einen Baustein für sich bildet. Der Vereinzelungseinrichtung ist ein weiterer Baustein mit einer Leiterplattenaufnahmeeinrichtung nachgeordnet, die wie die Vereinzelungseinrichtung selbständiger Bestandteil einer Zwischeneinrichtung ist. Die Leiterplattenaufnahmeeinrichtung ist wendbar, so daß mit ihr die Leiterplatten vor Einführung in die Leiterplattenbearbeitungseinrichtung gewendet werden können.

Ferner sind sowohl für das Drehen von vereinzelten Leiterplatten als auch für ihr Wenden separate Bausteine bekannt, die beim Aufbau einer Anlage mit einer Leiterplattenbearbeitungseinrichtung in die Anlage an den entsprechenden Stellen eingefügt werden (vgl. Info 2/1186/TK 3000 der Firma Universal Instruments GmbH und Prospektblatt "CONCEPTRONIC LEITERPLATTEN-TRANSPORTWEICHE CT-BH. 6480" der Firma Conceptronic).

Dadurch, daß in den bekannten Anlagen jeder Funktion, wie dem Vereinzeln, dem Drehen und dem Wenden der zu bearbeitenden Leiterplatten, jeweils ein separater Baustein zugeordnet wird, ergeben sich relativ lange Anlagen.

Gemäß der Erfindung ist bei einer Vorrichtung zum Be- und/oder Entladen einer Leiterplattenbearbeitungseinrichtung der eingangs angegebenen Art die Leiterplattenaufnahmeeinrichtung um eine horizontale Achse drehbar.

Der wesentliche Vorteil der erfindungsgemäßen Vorrichtung besteht darin, daß bei ihr außer der Funktion des Wendens auch die Funktion des Drehens einer zu bearbeitenden Leiterplatte um eine horizontale Achse mit ein und derselben Einrichtung, nämlich der Leiterplattenaufnahmeeinrichtung, vorgenommen wird, da diese Leiterplattenaufnahmeeinrichtung nicht nur wendbar, sondern auch um eine horizontale Achse drehbar ist. Bei der erfindungsgemäßen Vorrichtung ist also neben einer Einrichtung zum Wenden der jeweils zu bearbeitenden Leiterplatte nicht noch eine weitere Einrichtung zu ihrer Drehung erforderlich, so daß auf zwei selbständige Bausteine unter Platzgewinn verzichtet werden kann.

Im Hinblick auf einen möglichst kompakten Aufbau einer Anlage mit einer Leiterplattenbearbeitungeinrichtung ist die erfindungsgemäße Vorrichtung so ausgebildet, daß die Leiterplattenaufnahmeeinrichtung in der Zwischeneinrichtung vor einer Leiterplattenspeichereinrichtung vertikal verfahrbar ist und daß auf der von der Leiterplattenaufnahmeeinrichtung abgewandten Seite der Leiterplattenspeichereinrichtung gemeinsam mit der Leiterplattenaufnahmeeinrichtung eine Schiebeeinrichtung zum Verschieben der Leiterplatten aus der Leiterplattenspeichereinrichtung in die Leiterplattenaufnahmeeinrichtung vertikal verfahrbar ist. Bei dieser Ausgestaltung der erfindungsgemäßen Vorrichtung ist in die Leiterplattenaufnahmeeinrichtung noch eine zusätzliche Funktion integriert, nämlich die Funktion des Vereinzeln der Leiterplatten bzw. deren Entnahme aus der Leiterplattenspeichereinrichtung.

Bei einer weiteren vorteilhaften Ausgestaltung der erfindungsgemäßen Vorrichtung ist die Leiterplattenaufnahmeeinrichtung quer zur Einschubrichtung der Leiterplatten in ihrer Lage einstellbar. Bei einer derart ausgestalteten Vorrichtung ist dann mit der Leiterplattenaufnahmeeinrichtung auch die Justierung der jeweils zu bearbeitenden Leiterplatte quer zu ihrer Transportrichtung möglich, wodurch ein ansonsten zusätzlicher Baustein entfällt.

In Abweichung von der eben dargelegten Ausgestaltung der erfindungsgemäßen Vorrichtung kann zur seitlichen Justierung der Leiterplatten vor ihrer Bearbeitung auch die Leiterplattenspeichereinrichtung quer zur Einschubrichtung in ihrer Lage einstellbar sein.

Bei der erfindungsgemäßen Vorrichtung sitzt vorteilhafterweise ein Rahmen der Leiterplattenaufnahmeeinrichtung auf einer vertikalen Antriebswelle eines Drehzwischenteils und das Drehzwischenteil auf einer horizontalen Antriebswelle eines Wendeteils. Auf diese Weise ist konstruktiv einfach die Leiterplattenaufnahmeeinrichtung so ausgestaltet, daß mit ihr sowohl ein Wenden als auch ein Drehen der jeweils zu bearbeitenden Leiterplatten möglich ist.

Bei einer solchermaßen ausgestalteten Leiterplattenaufnahmeeinrichtung sind die vertikale und die horizontale Antriebswelle in vorteilhafter Weise durch jeweils einen Motor angetrieben, weil sich auf diese Weise der Antrieb der beiden Antriebswellen am einfachsten bewirken läßt.

Zur Erläuterung der Erfindung ist in

Figur 1 in perspektivischer Darstellung eine Anlage mit einer Leiterplattenbearbeitungseinrichtung sowie Vorrichtungen zu deren Be- und/oder Entladen und in

Figur 2 ein Ausschnitt aus Figur 1 mit der erfindungsgemäß ausgebildeten Leiterplattenaufnahmeeinrichtung in Form einer Sprengzeichnung gezeigt.

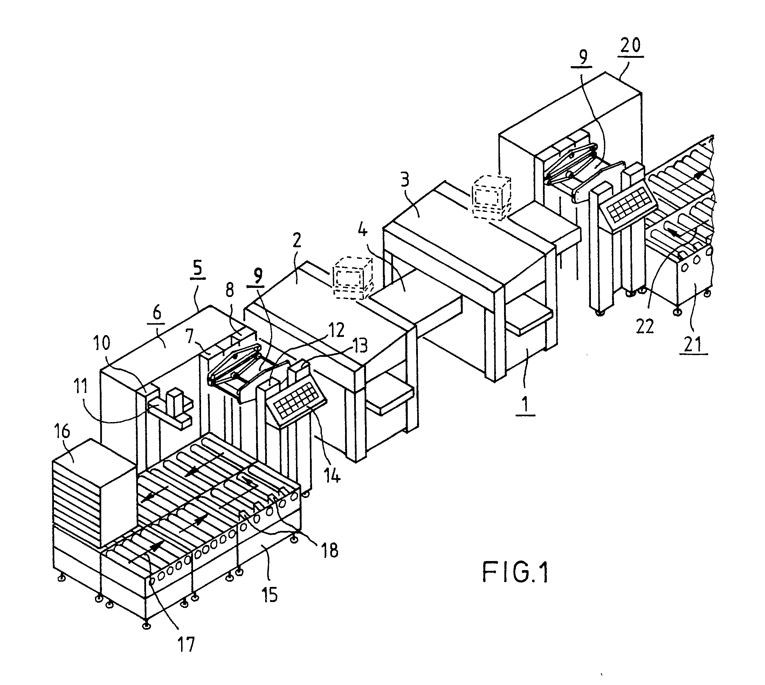

Die in Figur 1 dargestellte Anlage zur Leiterplattenbearbeitung enthält eine Leiterplattenbearbeitungseinrichtung 1, die aus zwei Bestückplätzen 2 und 3 besteht. Die beiden Bestückplätze 2 und 3 sind über eine Fördereinrichtung 4 unmittelbar miteinander verbunden.

Der Leiterplattenbearbeitungseinrichtung 1 ist eine Zwischeneinrichtung 5 vorgeordnet, die einen Schrank 6 enthält. Dieser Schrank 6 ist mit Führungssäulen 7 und 8 versehen, mittels denen eine Leiterplattenaufnahmeeinrichtung 9 vertikal verfahrbar ist. An einer zusätzlichen Säule 10 des Schrankes 6 ist eine Schiebeeinrichtung 11 vertikal verfahrbar angeordnet. Mit dem Schrank 6 sind ferner 2 Haltesäulen 12 und 13 verbunden, an denen ein Bedienungspult 14 angebracht ist.

Der Zwischeneinrichtung 5 ist eine Transporteinrichtung 15 zugeordnet, auf der über Rollen Leiterplattenspeichereinrichtungen in Form von Magazinen 16 transportiert werden können. Die Magazine 16 werden bei der dargestellten Anlage in Richtung der Pfeile 17 geführt, wobei die Positionierung der Leiterplattenspeichereinrichtungen 16 vor der Leiterplattenaufnahmeeinrichtung 9 mittels einer Fixierbzw. Spannvorrichtung 18 erfolgt, die mit Ansätzen seitlich gegen die Leiterplattenspeichereinrichtungen fährt und diese in Richtung auf den Schrank 6 in eine bestimmte, vorgegebene Position bewegt.

Der Leiterplattenbearbeitungseinrichtung 1 ist in Transportrichtung der Leiterplatten eine weitere Zwischeneinrichtung 20 nach geordnet, die - bis auf die Schiebeeinrichtung - ebenso ausgebildet ist wie die Zwischeneinrichtung 5. Die Verbindung der weiteren Zwischeneinrichtung 20 mit der Leiterbearbeitungseinrichtung 1 erfolgt über ein in der Figur 1 nur schematisch dargestelltes Förderband; entsprechend ist im übrigen die Leiterplattenaufnahmeeinrichtung 9 der Zwischeneinrichtung 5 mit dem Bestücktisch 2 verbunden. Eine weitere Transporteinrichtung 21 dient dazu, nicht dargestellte, leere Speichermagazine in Richtung der Pfeile 22 in eine Position hinter der Leiterplattenaufnahmeeinrichtung 9 der weiteren Zwischeneinrichtung 20 zu positionieren und nach Befüllung von dort abzutransportieren.

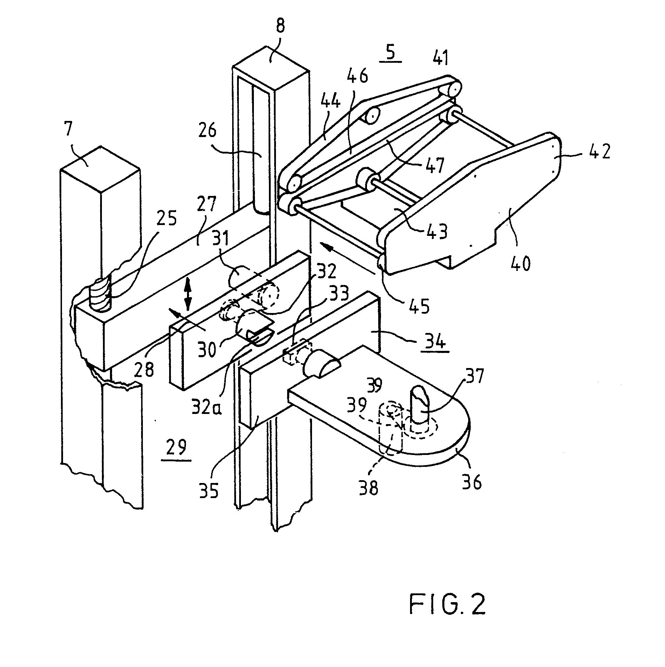

Der in Figur 2 dargestellte Ausschnitt der Zwischeneinrichtung 5 zeigt, daß in den Führungssäulen 7 und 8 jeweils eine Spindel 25 bzw. 26 verläuft; beide Spindeln 25 und 26 werden in nicht dargestellter Weise gleichmäßig angetrieben. Über diese Spindeln 25 und 26 wird ein Tragbalken 27 der Leiterplattenaufnahmeeinrichtung 9 vertikal bewegt. An diesem Tragbalken 27 ist in nicht erkennbarer Weise ein Wendeteil 29 um eine Achse 28 drehbar befestigt. Dieses Wendeteil 29 trägt eine horizontale Antriebswelle 30, die von einem Elektromotor 31 über einen schematisch dargestellten Riementrieb 32 antreibbar ist. Die horizontale Antriebswelle 30 greift mit ihrem Schlitz 30a in einen in Figur 2 strichliert angedeuteten Ansatz 33 eines Drehteils 34 ein. Dieses Drehteil 34 ist mittels des Ansatzes 33 fest mit der Antriebswelle 30 des Wendeteils 29 verbunden. Auf der vom Wendeteil 29 abgewandten Seite des Drehteils 34 ist an einer Tragplatte 35 des Drehteils 34 eine Halteplatte 36 angebracht, auf der eine vertikale Antriebswelle 37 drehbar gelagert ist. An der Halteplatte 36 ist ein weiterer Elektromotor 38 befestigt, der über einen weiteren Riementrieb 39 die Antriebswelle 37 in Drehbewegungen versetzen kann.

Auf der vertikalen Antriebswelle 37 des Drehteils 34 sitzt fest ein Rahmen 40 der Leiterplattenaufnahmeeinrichtung 9. Dieser Rahmen 40 besteht aus zwei Seitenteilen 41 und 42, die durch ein Bodenteil 43 miteinander verbunden sind. In den Seitenteilen 41 und 42 sind Rollen für jeweils einen Riementrieb 44 und 45 gelagert. An den Seitenteilen 41 und 42 sind ferner steuerbare Anschläge für die zwischen den Riemenabschnitten 46 und 47 der Riementriebe 44 und 45 eingebrachten Leiterplatten vorgesehen; der besseren Übersichtlichkeit halber sind diese Anschläge in der Figur nicht dargestellt.

In Abweichung von der Darstellung nach Figur 2 kann der Tragbalken 27 von einem Riementrieb verstellbar sein. An dem Tragbalken kann als Wendeteil ein Kegelrad gelagert sein, das unter Bildung eines Kegelradgetriebes von einem weiteren Kegelrad auf der Antriebswelle eines Motors angetrieben wird, der ebenfalls auf dem Tragbalken befestigt ist.

Unter Bezugnahme auf die Figuren 1 und 2 wird nachfolgend der Durchgang einer zu bearbeitenden Leiterplatte durch die dargestellte Anlage beschrieben: Zunächst wird ein Magazin 16 mit zu bearbeitenden Leiterplatten in eine vorbestimmte Position vor der Leiterplattenaufnahmeeinrichtung 9 der Zwischeneinrichtung 5 gebracht. Danach wird die Leiterplatten-Aufnahmeeinrichtung 9 und synchron mit ihr die Schiebeeinrichtung 11 in eine derartige Position vertikal verfahren, daß die zu entnehmende Leiterplatte zwischen der Schiebeeinrichtung 11 und der Aufnahmeeinrichtung 9 liegt. Danach wird die Schiebeeinrichtung 11 betätigt, wodurch die Leiterplatte zwischen die Riemenabschnitte 46 und 47 der Leiterplattenaufnahmeeinrichtung 9 gelangt. Durch Betätigen des Elektromotors 31 wird dann beispielsweise die Leiterplatte gewendet und anschließend oder gleichzeitig durch Betätigen des weiteren Elektromotors 38 um beispielsweise 180° gedreht. Nach Ablauf all dieser Maßnahmen befindet sich dann die Leiterplatte in der Position, in der sie ausgerichtet über das verbindende Förderband in den ersten Bestückplatz 2 einläuft. Nach Bestückung und Weitertransport in den weiteren Bestückplatz 3 gelangt die zum zweiten Mal bestückte Leiterplatte in die Leiterplattenaufnahmeeinrichtung 9 der weiteren Zwischeneinrichtung 20 und wird durch vertikales Bewegen dieser Leiterplattenaufnahmeeinrichtung vor das Fach des nicht dargestellten Magazins gebracht, in das die bearbeitete Leiterplatte eingebracht werden soll. Gleichzeitig damit ist eine der besseren Übersichtlichkeit halber in die Figur 1 nicht dargestellte weitere Schiebeeinrichtung vor der Aufnahmeeinrichtung vertikal verfahren worden, die nach Erreichen der gewünschten Endlage die bearbeitete Leiterplatte in das Magazin einschiebt. Damit ist die Bearbeitung der Leiterplatte beendet.

**Patentansprüche**

1. Vorrichtung zum Be- und/oder Entladen einer Leiterplatten-bearbeitungseinrichtung, insbesondere einer Leiterplattenbestückeinrichtung (1), mit
einer der Leiterplattenbearbeitungseinrichtung (1) zugeordneten,
die jeweilige Leiterplatte aufnehmenden Zwischeneinrichtung (5) mit wendbarer Leiterplattenaufnahmeeinrichtung (9),
**dadurch gekennzeichnet, daß**
die Leiteraufnahmeeinrichtung (9) um eine horizontale Achse drehbar ist.

2. Vorrichtung nach Anspruch 1,
**dadurch gekennzeichnet, daß**
die Leiterplattenaufnahmeeinrichtung (9) in der Zwischeneinrichtung (5) vor einer Leiterplattenspeichereinrichtung (16) vertikal verfahrbar ist und daß
auf der von der Leiterplattenaufnahmeeinrichtung (9) abgewandten Seite der Leiterplattenspeichereinrichtung (16) gemeinsam mit der Leiterplattenaufnahmeeinrichtung (9) eine Schiebeeinrichtung (11) zum Verschieben der Leiterplatten aus der Leiterplattenspeichereinrichtung (16) in die Leiterplattenaufnahmeeinrichtung (9) vertikal verfahrbar ist.

3. Vorrichtung nach Anspruch 1 oder 2,
**dadurch gekennzeichnet, daß**
die Leiterplattenaufnahmeeinrichtung quer zur Einschubrichtung der Leiterplatten in ihrer Lage einstellbar ist.

4. Vorrichtung nach Anspruch 1 oder 2,
**dadurch gekennzeichnet, daß**
die Leiterplattenspeichereinrichtung (16) quer zur Einschubrichtung der Leiterplatten in ihrer Lage einstellbar ist.

5. Vorrichtung nach einem der vorangehenden Ansprüche,
**dadurch gekennzeichnet, daß**
ein Rahmen (40) der Leiterplattenaufnahmeeinrichtung (9) auf einer vertikalen Antriebswelle (37) eines Drehzwischenteils (34) sitzt und daß das Drehzwischenteil (34) auf einer horizontalen Antriebswelle (30) eines Wendeteils (29) sitzt.

6. Vorrichtung nach Anspruch 5,
**dadurch gekennzeichnet, daß**
die vertikale und die horizontale Antriebswelle (30, 37) durch jeweils einen Motor (31, 38) angetrieben sind.

FIG.1

FIG.2